# EUROPÄISCHE PATENTSCHRIFT

(11) **EP 1 186 037 B1**
(45) Veröffentlichungstag und Bekanntmachung des Hinweises auf die Patenterteilung: **16.11.2005**
(21) Anmeldenummer: 00945592.4
(22) Anmeldetag: 30.05.2000
(51) Int. Cl.: H01L 23/495, H01L 25/065

(54) **MULTICHIPMODUL FÜR DIE LOC-MONTAGE SOWIE VERFAHREN ZU DESSEN HERSTELLUNG.**
MULTI-CHIP MODULE FOR LEADS-ON-CHIP (LOC) ASSEMBLY AND METHOD FOR PRODUCTION OF THE SAME.
MODULE MULTIPUCE POUR MONTAGE "FILS SUR PUCE" ET SON PROCEDE DE PRODUCTION

(30) Priorität: 17.06.1999 DE 19927747
(43) Veröffentlichungstag der Anmeldung: 13.03.2002
(73) Patentinhaber: Infineon Technologies AG, 81669 München (DE)
(72) Erfinder: WÖRZ, Andreas, D-93309 Kelheim (DE); VIDAL, Ulrich, D-84034 Landshut (DE); FERSTL, Klemens, D-93051 Regensburg (DE)
(74) Vertreter: Bickel, Michael
(86) Internationale Anmeldenummer: PCT/DE2000/001767
(87) Internationale Veröffentlichungsnummer: WO 2000/079591

(56) Entgegenhaltungen:
- DE-A- 4 301 915
- DE-A- 19 704 385
- DE-A- 19 712 551
- US-A- 5 208 782
- US-A- 5 331 201
- US-A- 5 559 305

## Beschreibung

Die Erfindung betrifft ein Multichipmodul für die LOC-Montage gemäss Oberbegriff des Patentanspruchs 1 sowie ein Verfahren zu dessen Herstellung gemäss Oberbegriff des Patentanspruchs 11.

Bei der LOC-Montage (LOC steht für "Leads-On-Chip") von Halbleiterchips wird der einzelne Halbleiterchip mittels eines Befestigungsmittels (z.B. in Form eines doppelseitig mit Thermoplastkleber beschichteten Polyimidträgerbandes ("Tape")) mit einem Substratträger in Form eines Anschlussrahmens ("Leadframe") verbunden, bei dem mehrere Anschlussleitungen ("Leads") mit ihren freien Enden in den Anschlussrahmen hineinragen. Der Halbleiterchip liegt bei dieser Montageart im Anschlussrahmen unterhalb der freien Enden dieser Anschlussleitungen und ist mit dem dazwischen liegenden und doppelseitig klebenden Polyimidträgerband an diese freien Enden der Anschlussleitungen geklebt. Über Bonddrahtverbindungen ("Bonds") werden die einzelnen Anschlussleitungen anschließend mit entsprechenden metallischen Anschlussflecken ("Pads") auf der Oberseite des Halbleiterchips z.B mittels dünner Golddrähtchen elektrisch verbunden ("Bonden"). Der Halbleiterchip selbst ist nach seiner Herstellung (und vor der LOC-Montage) üblicherweise zunächst zusammen mit vielen anderen Halbleiterchips auf einer Waferscheibe angeordnet und wird vor seiner Verwendung in einer elektrischen oder elektronischen Schaltung, d.h. vor der LOC-Montage aus dieser Waferscheibe ausgesägt.

Bei der Montage von mehreren solcher vereinzelter Halbleiterchips in einem gemeinsamen Anschlussrahmen kann es durch Fertigungstoleranzen bei der Montage zu einem unerwünschten Versatz der einzelenen Chips untereinander kommen, der entsprechende Ungenauigkeiten und Fehler vor allem beim nachfolgen-, den Herstellen der Bondverbindungen zur Folge hat. Dies kann vor allem bei grossen Chipflächen zu wirtschaftlich nicht mehr vertretbaren Ausfällen im Montageprozess führen, wenn entsprechende Gehäusetoleranzen überschritten werden. Beim Herstellen der Bondverbindungen bei n Chips in einem Anschlussrahmen sind ausserdem im allgemeinen auch n aufeinanderfolgende Verbindungsschritte ("Diebond-Schritte") erforderlich, was zu entsprechend langen Produktionszeiten führt. Ferner können in solchen Fällen auch Probleme mit der Anbindung der einzelnen Chips in dem Anschlussrahmen auftreten, da die Chips je nach Anordnung der freien Enden der Anschlussleitungen im Anschlussrahmen in der Regel nur einseitig verbunden und damit während dieser Zeit mechanisch einseitig belastet werden.

Aus der DE 197 12 551 A1 ist ein Zuleitungsrahmen und ein Herstellungsverfahren für Halbleiterbauelemente bekannt, wobei der Zuleitungsrahmen derart ausgebildet ist, dass er auf einen Wafer, in dem eine Vielzahl von gleichartigen Bauelementen integriert sind, aufgebracht werden kann. Zur Herstellung der Bauelemente wird der Zuleitungsrahmen auf den Wafer aufgesetzt und dort mittels Drahtbrücken mit den einzelnen Halbleiterbauelementen verbunden. Daran schließt sich ein Vergießverfahren an, mittels welchem ein Bereich geformt wird, der die metallischen Drähte und Zuleitungen des Zuleitungsrahmens einschließt.

Die Aufgabe der Erfindung besteht daher darin, einerseits ein für die LOC-Montage geeignetes Multichipmodul mit mehreren Halbleiterchips in einem Anschlussrahmen zu schaffen, bei dem die Zahl der Ausfälle während der Montage möglichst gering ist; ferner sollte auch die Montagezeit gegenüber herkömmlichen Montagemethoden verringert werden können, und andererseits ein Verfahren zur Herstellung eines solchen für die LOC-Montage geeigneten Multichipmoduls anzugeben, das möglichst einfach und kostengünstig realisiert werden kann.

Die erfindungsgemäße Lösung dieser Aufgabe wird in Bezug auf das zu schaffende Multichipmodul durch die Merkmale des Patentanspruchs 1 und in Bezug auf das anzugebende Verfahren durch die Merkmale des Patentanspruchs 11 wiedergegeben. Die übrigen Patentansprüche (Ansprüche 2 bis 10) enthalten vorteilhafte Aus- und Weiterbildungen des erfindungsgemäßen Multichipmoduls.

Der Kern der Erfindung besteht darin, die Waferscheibe so zu zerteilen (z.B. zu zersägen), dass die für die Montage in dem Anschlussrahmen vorgesehenen Halbleiterchips (oder zumindest ein Teil dieser Chips) auf einem gemeinsamen, zusammenhängenden Teil der Waferscheibe verbleiben, der dann bei der LOC-Montage als ganzes in den Anschlussrahmen eingebracht wird. Anschließend werden die Anschlussleitungen mit ihren freien Enden, wie üblich, an den vorgesehenen Stellen auf der Oberseite der Chips befestigt (z.B. geklebt) und danach mit den Anschlussflecken auf der Oberseite der Chips elektrisch verbunden (z.B. mittels Bonddrahtverbindungen).

Ein wesentlicher Vorteil der erfindungsgemäßen Lösung ist hauptsächlich darin zu sehen, dass es keinen säge- und/oder montagebedingten Versatz zwischen den einzelnen Halbleiterchips gibt, der sich vor allem beim Bonden ungünstig auswirken würde. Generell können hierdurch Montagetoleranzen (z.B. beim Einsetzen des Waferscheibenteils mit den Chips in den Anschlussrahmen) erheblich, wenn nicht sogar auf ein vernachlässigbares Mass vermindert werden.

Ein weiterer Vorteil ist darin zu sehen, dass nur noch ein Bondvorgang pro Anschlussrahmen erforderlich ist, so dass auch die Montagezeiten erheblich verringert werden können.

Durch die vorgegebene unveränderbare Anordnung der Chips untereinander auf dem gemeinsamen, zusammenhängenden Waferscheibenteil ist schliesslich die Befestigung (z.B. die Verklebung) der freien Enden der Anschlussleitungen auf der Oberseite der Chips entsprechend einfach, schnell und genau (d.h. mit entsprechend reduzierten Toleranzen) durchführbar.

In einer vorteilhaften Ausführungsform des erfindungsgemäßen Multichipmoduls ist vorgesehen, dass die seitliche Kontur des gemeinsamen, zusammenhängenden Waferscheibenteils mit den darauf befindlichen Chips an die seitliche Kontur des Anschlussrahmens angepasst ist, z.B. dergestalt, dass die beiden Konturen umlaufend überall den gleichen oder zumindest annähernd den gleichen Abstand voneinander haben.

Der Vorteil dieser Lösung besteht darin, dass durch diese Konturanpassung die Montagetoleranzen noch weiter vermindert und inkorrekte Plazierungen der Chips im Anschlussrahmen verhindert werden können.

Im Hinblick auf die heute übliche rechteckige oder quadratische Form/Kontur der Chips hat es sich als zweckmässig erwiesen, dass auch der Anschlussrahmen eine rechteckförmige oder quadratische seitliche Kontur aufweist.

Dies ist vor allem dann von Vorteil, wenn die Anzahl der in dem Anschlussrahmen anzuordnenden Chips 2 oder ein Vielfaches von 2 beträgt, da dann in der Regel die Chips auf der Waferscheibe so angeordnet werden können, dass der gemeinsame Teil der Scheibe, der in den Anschlussrahmen eingebracht werden soll, ebenfalls eine rechteckförmige oder quadratische Kontur aufweist.

Im folgenden wird die Erfindung anhand der Figuren näher erläutert. Es zeigen
- Fig.1: einen Teil einer bevorzugten Ausführungsform des erfindungsgemäßen Multichipmoduls mit einem Halbleiterchippaar auf einem gemeinsamen Teil der Waferscheibe,
- Fig.2: eine erste vorteilhafte Ausbildung des erfindungsgemäßen Multichipmoduls mit dem Halbleiterchippaar gemäß Fig.1,
- Fig.3: eine zweite vorteilhafte Ausbildung des erfindungsgemäßen Multichipmoduls mit dem Halbleiterchippaar gemäß Fig.1,
- Fig.4: eine dritte vorteilhafte Ausbildung des erfindungsgemäßen Multichipmoduls mit dem Halbleiterchippaar gemäß Fig.1.

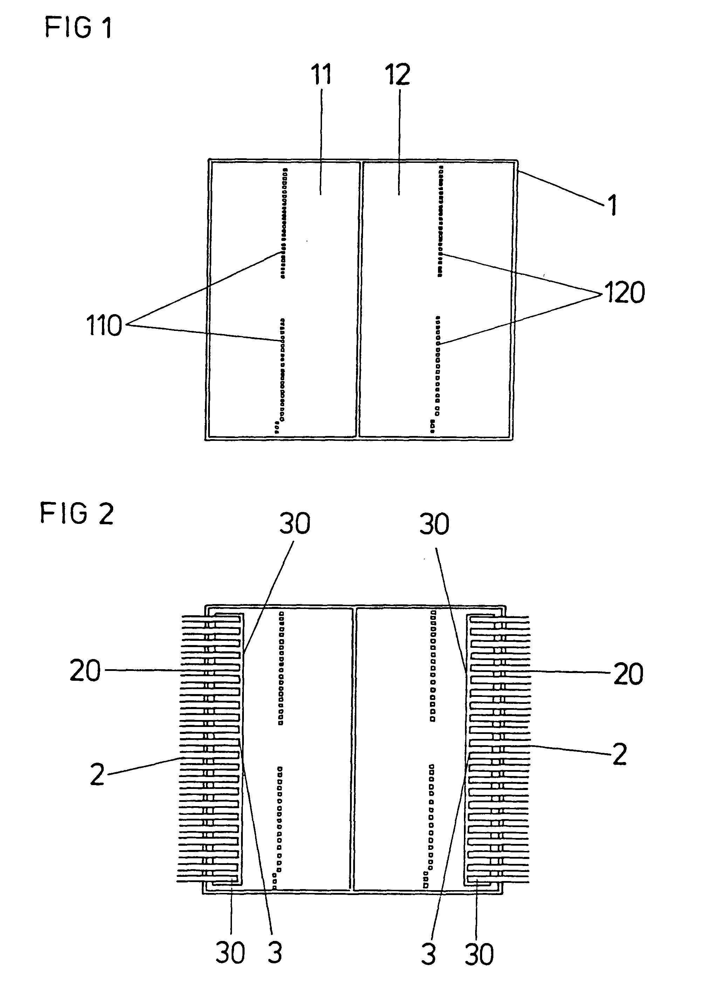

Fig.1 zeigt einen Teil 1 einer Waferscheibe mit zwei nebeneinander angeordneten rechteckförmigen Halbleiterchips 11 und 12, auf deren Oberseite eine Reihe von metallischen Anschlussflecken 110 und 120 angeordnet sind. Dieser (für beide Chips 11 und 12) gemeinsame, zusammenhängende Teil 1 der Waferscheibe kann z.B. durch Aussägen aus der Waferscheibe entnommen werden.

In der Ausführungsform des Multichipmoduls in Fig.2 ist dieser gemeinsame, zusammenhängende Teil 1 der Waferscheibe mit den beiden Chips 11 und 12 in einem Anschlussrahmen angeordnet, bei dem von zwei sich gegenüberliegenden Seiten Anschlussleitungen 2 herangeführt sind, die mit ihren freien Enden 20 über den Chips 11 und 12 in den Anschlussrahmen hineinragen und jeweils mittels eines Streifens 30 eines doppelseitig mit Thermoplastkleber beschichteten Polyimidträgerbandes 3 auf die Oberseite des entsprechenden Chips 11 bzw. 12 geklebt sind. In einem nachfolgenden Montageschritt, der hier nicht gezeigt ist, werden dann die freien Enden 20 der Anschlussleitungen 2 durch Bonden (z.B. mittels dünner Bonddrähte aus Gold) mit den Anschlussflecken 110 bzw. 120 auf der Oberseite des jeweiligen Halbleiterchips 11 bzw. 12 elektrisch verbunden.

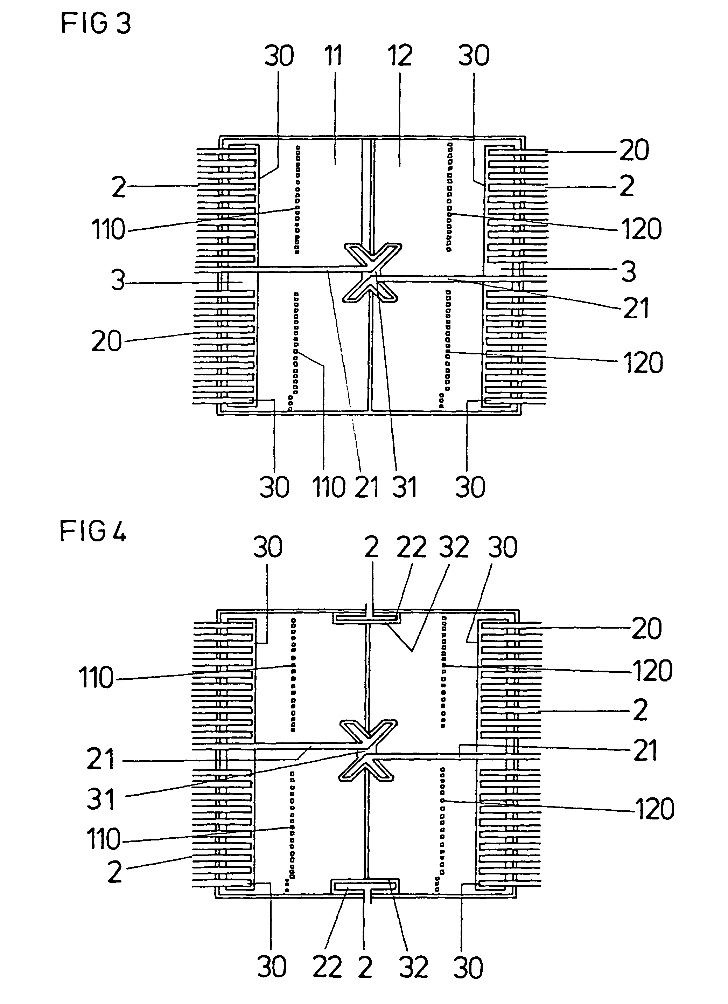

Die Ausführungsform des Multichipmoduls in Fig.3 unterscheidet sich von der Ausführungsform des Moduls in Fig.2 lediglich dadurch, dass zwei der Anschlussleitungen 2 mit ihren freien Enden 21 verlängert sind und mit entsprechend langen Klebestreifen 31 an beiden Chips 11 bzw. 12 festgeklebt sind, wobei die Enden 21 und der darunter befindliche Klebestreifen 31 schwalbenschwanzförmig aufgespalten sind. Die übrigen Teile des Moduls in Fig.2 stimmen mit den entsprechenden Teilen des Moduls in Fig.1 überein und tragen deshalb auch die gleichen Bezugszeichen wie in Fig.1. Bezüglich dieser für beide Figuren gemeinsamen Teile wird deshalb auf die Beschreibung zu Fig.1 verwiesen.

Der wesentliche Vorteil der Ausführungsform des Moduls in Fig.3 ist darin zu sehen, dass eine zusätzliche Stabilisierung des Waferscheibenteils zum Leadframerahmen erreicht wird.

Die Ausführungsform des Multichipmoduls in Fig.4 schliesslich unterscheidet sich von der Ausführungsform des Moduls in Fig. 3 lediglich dadurch, dass zusätzlich von den beiden bislang freien Seiten des Anschlussrahmens jeweils eine weitere Anschlussleitung 2 herangeführt ist, deren freies Ende 22 T-förmig ausgebildet ist und entsprechend mittels eines T-förmig ausgebildeten Klebestreifens 32 auf der Oberseite von beiden Chips 11 bzw. 12 festgeklebt ist. Die übrigen Teile des Moduls in Fig.4 stimmen mit den entsprechenden Teilen des Moduls in Fig.3 überein und tragen deshalb auch die gleichen Bezugszeichen wie in Fig.1 und 2. Bezüglich dieser für alle drei Figuren gemeinsamen Teile wird deshalb auf die Beschreibung zu Fig.1 und 2 verwiesen.

Der wesentliche Vorteil der Ausfuehrungsform des Moduls in Fig.4 ist darin zu sehen, dass eine weitere Stabilisierung des Waferscheibenteils erreicht wird.

Es ist z.B. möglich, anstelle der rechteckförmigen oder quadratischen seitlichen Konturen a) des gemeinsamen, zusammenhängenden Teils 1 der Waferscheibe mit den darauf befindlichen Chips 11 bzw. 12 und/oder b) des Anschlussrahmens eine andere Kontur zu wählen, die z.B. als Vieleck ausgebildet ist, das z.B. nur rechte Winkel aufweist. Dies kann vor allem dann von Vorteil sein, wenn die Anzahl der zu montierenden Chips pro Anschlussrahmen kein Vielfaches von 2 ist bzw. eine ungerade Zahl darstellt und/oder die Chips unterschiedliche Größen aufweisen. Im Falle von drei Chips z.B. wäre eine L-förmige seitliche Kontur denkbar. Natürlich können diese drei Chips auch nebeneinander auf einem rechteckförmigen oder ggf. sogar quadratischen gemeinsamen, zusammenhängenden Teil der Waferscheibe angeordnet werden.

Denkbar ist auch, weitere Anschlussleitungen mit ihren freien Enden an beiden Chips oder ggf. an mehr als zwei Chips zu befestigen (z.B. festzukleben).

## Patentansprüche

1. Multichipmodul für die LOC-Montage, bei dem mehrere Halbleiterchips nebeneinander in einem Anschlussrahmen angeordnet sind,
**dadurch gekennzeichnet, dass** ein Teil der oder alle in dem Anschlussrahmen angeordneten Halbleiterchips (11, 12) auf einem gemeinsamen, zusammenhängenden Teil (1) einer Waferscheibe angeordnet sind..

2. Multichipmodul nach Anspruch 1,
**dadurch gekennzeichnet, dass** dass die seitliche Kontur des gemeinsamen, zusammenhängenden Teils (1) der Waferscheibe mit den Halbleiterchips (11, 12) an die seitliche Kontur des Anschlussrahmens angepasst ist.

3. Multichipmodul nach Anspruch 2,
**dadurch gekennzeichnet, dass** die seitliche Kontur des gemeinsamen, zusammenhängenden Teils (1) der Waferscheibe mit den Halbleiterchips (11, 12) und die seitliche Kontur des Anschlussrahmens umlaufend einen konstanten oder zumindest annähernd konstanten Abstand voneinander haben.

4. Multichipmodul nach einem der Ansprüche 2 oder 3,
**dadurch gekennzeichnet, dass** die seitliche Kontur des Anschlussrahmens und/oder des gemeinsamen, zusammenhängenden Teils (1) der Waferscheibe mit den Halbleiterchips (11, 12) eine rechteckige oder quadratische Form aufweist.

5. Multichipmodul nach einem der vorhergehenden Ansprüche,
**dadurch gekennzeichnet, dass** die Zahl der auf dem gemeinsamen, zusammenhängenden Teil (1) der Waferscheibe angeordneten Halbleiterchips 2n beträgt mit n gleich einer natürlichen Zahl grösser oder gleich 1, vorzugsweise gleich 1 oder 2 oder 3 oder 4.

6. Multichipmodul nach einem der vorhergehenden Ansprüche,
**dadurch gekennzeichnet, dass** der Anschlussrahmen mehrere seitlich in den Anschlussrahmen hineinragende Anschlussleitungen (2) aufweist, dass die Anschlussleitungen (2) an ihren in den Anschlussrahmen hineinragenden freien Enden (20; 20, 21; 20, 21, 22) mit Hilfe von Befestigungsmitteln (3) auf der Oberseite der einzelnen Halbleiterchips (11, 12) befestigt und mit Hilfe von Bondverbindungen mit entsprechenden Anschlussflecken (110, 120) auf der Oberseite der einzelnen Halbleiterchips (11, 12) elektrisch verbunden sind

7. Multichipmodul nach Anspruch 6,
**dadurch gekennzeichnet, dass** als Befestigungsmittel (3) doppelseitig mit Thermoplastkleber beschichtete Trägerbänder (30; 30, 31; 30, 31, 32), vorzugsweise aus Polyimid, vorgesehen sind, die zwischen der Oberseite des entsprechenden Halbleiterchips (11, 12) und der Unterseite der freien Enden (20; 20, 21; 20, 21, 22) der Anschlussleitungen (2) angeordnet sind.

8. Multichipmodul nach einem der Ansprüche 6 oder 7,
**dadurch gekennzeichnet, dass** ein ausgewählter Teil der freien Enden (21; 21, 22) der Anschlussleitungen (2) an den Oberseiten von mindestens zwei Halbleiterchips (11, 12) befestigt und/oder mit den Anschlussflecken (110, 120) von mindestens zwei Halbleiterchips (11, 12) elektrisch verbunden sind.

9. Multichipmodul nach Anspruch 8,
**dadurch gekennzeichnet, dass** die freien Enden des ausgewählten Teils der freien Enden (21; 21, 22) der Anschlussleitungen (2) schwalbenschwanzförmige (21) oder T-förmige (22) Verzweigungen aufweisen und dass diese Verzweigungen jeweils an mindestens zwei Halbleiterchips (11, 12) befestigt sind.

10. Multichipmodul nach einem der Ansprüche 6 bis 9,
**dadurch gekennzeichnet, dass** die freien Enden (20; 20, 21; 20, 21, 22) der Anschlussleitungen (2) in ihrer Anordnung im Anschlussrahmen eine Spiegel- oder Rotations-Symmetrie aufweisen.

11. Verfahren zur Herstellung eines Multichipmoduls für die LOC-Montage nach einem der vorhergehenden Ansprüche, bei welchem Verfahren mehrere vor der LOC-Montage auf einer Waferscheibe angeordnete Halbleiterchips nebeneinander in einem Anschlussrahmen angeordnet werden,
**dadurch gekennzeichnet, dass** die in dem Anschlussrahmen realisierte Anordnung der Halbleiterchips (11, 12) in dieser Form bereits auf der Waferscheibe realisiert wird und dass der diese Anordnung der Halbleiterchips (11, 12) aufweisende Teil der Waferscheibe als gemeinsamer, zusammenhängender Teil (1) aus der Waferscheibe herausgetrennt und in dem Anschlussrahmen eingesetzt wird.

## Claims

1. Multichip module for LOC mounting, in which a number of semiconductor chips are arranged next to one another in a leadframe, **characterized in that** some or all of the semiconductor chips (11, 12) arranged in the leadframe are arranged on a common, contiguous part (1) of a wafer slice.

2. Multichip module according to Claim 1, **characterized in that** the lateral contour of the common, contiguous part (1) of the wafer slice with the semiconductor chips (11, 12) is adapted to the lateral contour of the leadframe.

3. Multichip module according to Claim 2, **characterized in that** the lateral contour of the common, contiguous part (1) of the wafer slice with the semiconductor chips (11, 12) and the lateral contour of the leadframe are at a constant or at least approximately constant distance from one another all the way around.

4. Multichip module according to either of Claims 2 and 3, **characterized in that** the lateral contour of the leadframe and/or of the common, contiguous part (1) of the wafer slice with the semiconductor chips (11, 12) has a rectangular or square form.

5. Multichip module according to one of the preceding claims, **characterized in that** the number of semiconductor chips arranged on the common, contiguous part (1) of the wafer slice is 2n, where n is equal to a natural number greater than or equal to 1, preferably equal to 1 or 2 or 3 or 4.

6. Multichip module according to one of the preceding claims, **characterized in that** the leadframe has a number of leads (2) protruding laterally into the leadframe, **in that** the leads (2) are fastened at their free ends (20; 20, 21; 20, 21, 22) protruding into the leadframe with the aid of fastening means (3) on the upper side of the individual semiconductor chips (11, 12) and are electrically connected with the aid of bonding connections to corresponding bonding pads (110, 120) on the upper side of the individual semiconductor chips (11, 12).

7. Multichip module according to Claim 6, **characterized in that** carrier tapes (30; 30, 31; 30, 31, 32), preferably of polyimide and coated on both sides with thermoplastic adhesive, which are arranged between the upper side of the corresponding semiconductor chip (11, 12) and the underside of the free ends (20; 20, 21; 20, 21, 22) of the leads (2), are provided as fastening means (3).

8. Multichip module according to either of Claims 6 and 7, **characterized in that** a selected part of the free ends (21; 21, 22) of the leads (2) are fastened to the upper sides of at least two semiconductor chips (11, 12) and/or are electrically connected to the bonding pads (110, 120) of at least two semiconductor chips (11, 12).

9. Multichip module according to Claim 8, **characterized in that** the free ends of the selected part of the free ends (21; 21, 22) of the leads (2) have dovetail-shaped (21) or T-shaped (22) branches and **in that** these branches are respectively fastened to at least two semiconductor chips (11, 12).

10. Multichip module according to one of Claims 6 to 9, **characterized in that** the free ends (20; 20, 21; 20, 21, 22) of the leads (2) have a mirror or rotational symmetry in their arrangement in the leadframe.

11. Method for producing a multichip module for LOC mounting according to one of the preceding claims, in which method a number of semiconductor chips arranged before LOC mounting on a wafer slice are arranged next to one another in a leadframe, **characterized in that** the arrangement of the semiconductor chips (11, 12) realized in the leadframe is already realized in this form on the wafer slice and **in that** the part of the wafer slice having this arrangement of the semiconductor chips (11, 12) is removed from the wafer slice as a common, contiguous part (1) and inserted in the leadframe.

## Revendications

1. Module multipuce pour montage (LOC) « fils sur puce » dans lequel plusieurs puces à semi-conducteur sont juxtaposées dans un cadre de connexion,
**caractérisé en ce qu'**
une partie ou toutes les puces à semi-conducteur (11, 12) placées dans le cadre de connexion sont disposées sur une partie (1) continue commune d'une plaquette.

2. Module multipuce selon la revendication 1,
**caractérisé en ce que**
le contour latéral de la partie (1) continue commune de la plaquette avec les puces à semi-conducteur (11, 12) est adapté au contour latéral du cadre de connexion.

3. Module multipuce selon la revendication 2,
**caractérisé en ce que**
le contour latéral de la partie (1) continue commune de la plaquette avec les puces à semi-conducteur (11, 12) et le contour latéral du cadre de connexion présentent une distance constante ou du moins approximativement constante l'un par rapport à l'autre sur la périphérie.

4. Module multipuce selon l'une quelconque des revendications 2 ou 3,
**caractérisé en ce que**
le contour latéral du cadre de connexion et/ou de la partie (1) continue commune de la plaquette avec les puces à semi-conducteur (11, 12) présente une forme rectangulaire ou carrée.

5. Module multipuce selon l'une quelconque des revendications précédentes,
**caractérisé en ce que**
le nombre de puces à semi-conducteur disposées sur la partie (1) continue commune de la plaquette est de 2n, n étant égal à un entier naturel supérieur ou égal à 1, de préférence égal à 1 ou 2 ou 3 ou 4.

6. Module multipuce selon l'une quelconque des revendications précédentes,
**caractérisé en ce que**
le cadre de connexion présente plusieurs lignes de connexion
(2) saillant latéralement dans le cadre de connexion, et les lignes de connexion (2), au niveau de leurs extrémités libres (20 ; 20, 21 ; 20, 21, 22) saillant dans le cadre de connexion, sont fixées à l'aide de moyens de fixation (3) à la face supérieure des différentes puces à semi-conducteur (11, 12) et reliées électriquement à l'aide de liaisons de contact à des points de connexion (110, 120) correspondants situés à la face supérieure des différentes puces à semi-conducteur (11, 12).

7. Module multipuce selon la revendication 6,
**caractérisé en ce que**
comme moyens de fixation (3), des bandes de support (30 ; 30, 31 ; 30, 31, 32), de préférence en polyimide, revêtues aux deux faces d'une colle thermoplastique sont disposées entre la face supérieure de la puce à semi-conducteur (11, 12) correspondante et la face inférieure des extrémités libres (20 ; 20, 21 ; 20, 21, 22) des lignes de connexion.

8. Module multipuce selon l'une quelconque des revendications 6 ou 7,
**caractérisé en ce qu'**
une partie sélectionnée des extrémités libres (21 ; 21, 22) des lignes de connexion (2) sont fixées aux faces supérieures d'au moins deux puces à semi-conducteur (11, 12) et/ou reliées électriquement aux points de connexion (110, 120) d'au moins deux puces à semi-conducteur (11, 12).

9. Module multipuce selon la revendication 8,
**caractérisé en ce que**
les extrémités libres de la partie sélectionnée des extrémités libres (21 ; 21, 22) des lignes de connexion (2) présentent des branchements en forme de queue d'aronde (21) ou en forme de T (22), et ces branchements sont respectivement fixés à au moins deux puces à semi-conducteur (11, 12).

10. Module multipuce selon l'une quelconque des revendications 6 à 9,
**caractérisé en ce que**
les extrémités libres (20 ; 20, 21 ; 20, 21, 22) des lignes de connexion (2) présentent au niveau de leur disposition dans le cadre de connexion une symétrie à miroir ou à rotation.

11. Procédé de fabrication d'un module multipuce pour le montage LOC (« fils sur puce ») selon l'une quelconque des revendications précédentes, dans lequel plusieurs puces à semi-conducteur disposées sur une plaquette avant le montage « fils sur puce » sont juxtaposées dans un cadre de connexion,
**caractérisé en ce que**
la disposition des puces à semi-conducteur (11, 12) réalisée dans le cadre de connexion est déjà réalisée sous cette forme sur la plaquette, et la partie de la plaquette présentant cette disposition des puces à semi-conducteur (11, 12) est séparée de la plaquette en tant que partie (1) continue commune et insérée dans le cadre de connexion.
